Europäisches Patentamt

European Patent Office

Office européen des brevets

(19)

(11) Veröffentlichungsnummer: **0 004 563**
**B1**

(12) **EUROPÄISCHE PATENTSCHRIFT**

(45) Veröffentlichungstag der Patentschrift: **16.06.82**

(51) Int. Cl.³: **H 03 H 15/02, H 01 L 27/10**

(21) Anmeldenummer: **79100653.9**

(22) Anmeldetag: **05.03.79**

(54) Transversalfilter.

(30) Priorität: **31.03.78 DE 2813972**
**31.03.78 DE 2813971**
**31.03.78 DE 2813998**
**31.03.78 DE 2813997**

(43) Veröffentlichungstag der Anmeldung:
**17.10.79 Patentblatt 79/21**

(45) Bekanntmachung des Hinweises auf die Patenterteilung:
**16.06.82 Patentblatt 82/24**

(84) Benannte Vertragsstaaten:
**BE FR GB IT NL**

(56) Entgegenhaltungen:
**FR - A - 2 375 766**
**NL - A - 7 710 541**
**US - A - 4 035 628**
**US - A - 4 080 581**
**SIEMENS FORSCHUNGS- UND ENT-**
**WICKLUNGSBERICHTE, Band 7, no. 3 Mai-Juni**
**1978 Berlin DE**
**K. KNAUER: "CCD Transversal Filters with**
**parallelin/serial-out configuration", Seiten**
**138—142**

(73) Patentinhaber: **SIEMENS AKTIENGESELLSCHAFT**
**Berlin und München**
**Postfach 22 02 61**
**D-8000 München 22 (DE)**

(72) Erfinder: **Knauer, Karl, Dipl.-Ing.**
**Dachsbergstrasse 13**
**D-8011 Kirchseeon (DE)**
Erfinder: **Pfleiderer, Hans-Jörg, Dr.**
**Franz-Krinninger-Weg 23**
**D-8011 Zorneding (DE)**

Transversalfilter

Die Erfindung bezieht sich auf ein Transversalfilter, bei dem die Stufen eines auf einem dotierten Halbleitersubstrat integrierten, analogen CTD-Schieberegisters mit Paralleleingängen und diesen zugeordneten Bewertungsschaltungen versehen sind, bei dem die Bewertungsschaltungen jeweils ein entgegengesetzt zu dem Substrat dotiertes Gebiet, ein erstes und zweites Eingangsgate und ein Transfergate aufweisen, wobei das Transfergate unmittelbar neben dem Transferkanal eines CTD-Schieberegisters angeordnet ist, das eine Eingangsgate mit einem Eingangssignal, das andere Eingangsgate mit einer konstanten Gleichspannung, das entgegengesetzt dotierte Gebiet mit einer ersten und das Transfergate mit einer zweiten Taktspannung beschaltet sind, und bei dem das Ausgangssignal an einem Ausgang des CTD-Schieberegisters abgreifbar ist.

Ein derartiges Transversalfilter ist aus der Zeitschrift "Electronics Letters", Bd. 13, Nr. 5 vom 3. März 1977, Seiten 126 und 127, bekannt. Die Größe der einzelnen Koeffizienten, mit denen das Eingangssignal an jedem Paralleleingang individuell bewertet wird, ist dabei durch die Kapazität des zweiten Eingangsgate gegeben. Transversalfilter dieser Gattung bilden auch den Gegenstand der deutschen Patentanmeldung P 26 43 704.7. Nachteilig ist hierbei, daß große Beträge der Bewertungskoeffizienten die für das Transversalfilter vorzusehende Halbleiterfläche entsprechend vergrößern.

Aus den "Proceedings of the 8th Conference (1976 International) on Solid State Devices, Tokyo, 1976", abgedruckt im "Japanese Journal of Applied Physics", Vol. 16 (1977) Supplement 16—1, Seiten 387—390, ist ein solches Transversalfilter bekannt, bei dem ein CCD-Schieberegister mehrere durch Trenndiffusionen gegeneinander isolierte Transferkanäle aufweist, die den Paralleleingängen jeweils individuell zugeordnet sind. Hierbei besteht das in den Bewertungsschaltungen jeweils vorgesehene Transfergate aus der ersten Verschiebeelektrode des zugehörigen Transferkanals. Die Transferkanäle werden in einer gemeinsamen Ausgangsstufe zusammengeführt, in deren Bereich die genannten Trenndiffusionen weggelassen sind. Da erfolgt eine Summierung der über die Kanäle getrennt übertragenen und mit unterschiedlichen Verzögerungen eintreffenden Signalanteile zu einem Ausgangssignal. Die Bewertungskoeffizienten, mit denen das den Paralleleingängen zugeführte Signal belegt wird, sind durch die Gateflächen in den einzelnen Bewertungsschaltungen gegeben. Nachteilig ist hierbei, daß die erforderliche Halbleiterfläche mit der Anzahl der Paralleleingänge und den gewünschten Beträgen der Bewertungskoeffizienten stark ansteigt.

Aus den oben genannten "Proceedings", abgedruckt in dem "Japanese Journal of Applied Physics", Vol. 16 (1977), Supplement 16—1, Seiten 391—396, ist ein weiteres Transversalfilter bekannt, das sich von der eingangs erwähnten Gattung durch eine andere Ausbildung von Bewertungsschaltungen und der Paralleleingänge unterscheidet. Jede einzelne Bewertungsschaltung enthält hier zwei in Serie geschaltete MOS-Feldeffekttransistoren und eine Widerstandsdiffusion, während jeder Paralleleingang eine mit einer Eingangsdiffusion versehene Stufe eines 4-Phasen-CCD-Schieberegisters aufweist. Dabei ist die Eingangsdiffusion mit einem Anschluß des Widerstandes verbunden und die letzte Verschiebeelektrode zu einer Verschiebeelektrode eines die Summierung der Signalanteile vornehmenden CCD-Schieberegisters benachbart angeordnet. Das Gate des einen MOS-Feldeffekttransistors jeder Bewertungsschaltung wird mit dem Eingangssignal belegt, das Gate des anderen jeweils mit einer Gleichspannung, die durch ihre Größe den durch die Transistoren fließenden Strom und damit den jeweiligen Bewertungskoeffizienten bestimmt. Damit sind die Übertragungseigenschaften des Transversalfilters elektrisch einstellbar. Nachteilig ist jedoch, daß der Strom nur in einem kleinen Änderungsbereich linear von der genannten Gleichspannung abhängt.

Es wurde bereits vorgeschlagen, vgl. die ältere deutsche Patentanmeldung P 26 44 284.2, bei einem Transversalfilter der eingangs genannten Art in den einzelnen Bewertungsschaltungen zur Realisierung eines Bewertungskoeffizienten jeweils zweimal hintereinander Ladungsmengen zu bilden und in die zugehörigen Stufen des CTD-Schieberegisters einzugeben, um die Bewertungsschaltungen flächensparend ausbilden zu können.

Der vorliegenden Erfindung liegt die Aufgabe zugrunde, ein Transversalfilter der eingangs genannten Art vorzusehen, das auf einer möglichst kleinen Oberfläche des Halbleitersubstras aufgebaut ist und trotzdem eine elektrische Einstellung der Bewertungskoeffizienten innerhalb eines großen relativen Einstellbereiches erlaubt. Das wird gemäß der Erfindung durch die im kennzeichnenden Teil der Patentansprüche 1, 3, 5 oder 7 angeführten Maßnahmen erreicht.

Der mit einem gemäß Patentanspruch 1 ausgebildeten, ersten Ausführungsbeispiel der Erfindung erzielte Vorteil besteht insbesondere darin, daß durch die Ansteuerung der Bewertungsschaltungen mit Taktspannungen unterschiedlicher Impulsfolgefrequenzen in einfacher und flächensparender Weise festgelegt wird, wie oft aus den einzelnen Bewertungsschaltungen durch deren Flächen gegebene Ladungsmengen in die zugehörigen Stufen des CTD-Schieberegisters eingegeben werden, wobei sich aus der Anzahl der jeweils eingegebenen Ladungsmengen die den Bewertungsschaltungen zugeordneten Bewertungskoeffizienten ergeben. Da das Eingeben der Ladungsmengen mit einer wesentlich höheren Frequenz erfolgen kann als das Takten des CTD-Schieberegisters, ist es möglich, für die Bewertungskoeffizienten große relative Einstellbereiche vorzusehen, die beispielsweise Größenverhältnisse von 1:1000 oder mehr einschließen. Zwischen der die Einstellung eines Bewertungskoeffizienten kontrollierenden Größe, das heißt der Impulsfolgefrequenz der der Bewertungsschaltung zugeführten Taktspannung, und dem eingestellten Bewertungskoeffizienten besteht dabei eine lineare Abhängigkeit. Die innerhalb weiter Grenzen gegebene Einstellbarkeit der Bewertungskoeffizienten ermöglicht eine sehr vielseitige Anwendung eines solchen Transversalfilters.

Der mit einem gemäß Patentanspruch 3 ausgebildeten, zweiten Ausführungsbeispiel der Erfindung erzielte Vorteil besteht insbesondere darin, daß durch die Ansteuerung der zusätzlichen, entgegengesetzt dotierten Gebiete einzelner oder mehrerer Bewertungsschaltungen mittels einer zusätzlichen Taktspannung einzelne oder mehrere Bewertungskoeffizienten mit einem minimalen Flächenaufwand in ihren Beträgen stark angehoben werden können.

Der mit einem gemäß Patentanspruch 5 ausgebildeten, dritten Ausführungsbeispiel der Erfindung erzielte Vorteil besteht insbesondere darin, daß durch die Aufteilung der für einen bestimmten Bewertungskoeffizienten erforderlichen Fläche des zweiten Eingangsgate auf die einander entsprechenden Eingangsgateelektroden zweier auf verschiedenen Seiten des CTD-Transferkanals angeordneter, einander an derselben Stufe des Schieberegisters gegenüberliegender Bewertungsschaltungen die Längen dieser beiden Elektroden nur halb so groß sind wie die des zweiten Eingangsgate einer einzigen Bewertungsschaltung, die denselben Bewertungskoeffizienten liefert. Damit entspricht die Zeit für das Einlesen einer den Bewertungskoeffizienten bestimmenden Ladungsmenge, die bei zwei einander gegenüberliegenden Bewertungsschaltungen benötigt wird, nur etwa einem Viertel der beim Einlesen derselben Ladungsmenge über eine einzige Bewertungsschaltung erforderlichen Zeit. Hieraus ergibt sich eine Anwendbarkeit des erfindungsgemäßen Transversalfilters in einem höheren Arbeitsfrequenzbereich, als dies unter Verwendung von bekannten Transversalfiltern möglich ist.

Der mit einem gemäß Patentanspruch 7 ausgebildeten, vierten Ausführungsbeispiel der Erfindung erzielte Vorteil besteht insbesondere darin, daß durch die Ausbildung der Dickschicht- und Dünnschichtbereiche der Isolierschicht unterhalb der Transfergateelektroden der Bewertungsschaltungen in einfacher und flächensparender Weise festgelegt wird, wie oft aus den einzelnen Bewertungsschaltungen durch deren Fläche gegebene Ladungsmengen in die zugehörigen Stufen des CTD-Schieberegisters eingegeben werden, wobei sich aus der Anzahl der jeweils eingegebenen Ladungsmengen die den Bewertungsschaltungen zugeordneten Bewertungskoeffizienten ergeben. Hieraus ergibt sich die Möglichkeit, das Transversalfilter nach der Erfindung in einfacher Weise mit wesentlich voneinander abweichenden Bewertungskoeffizienten auszustatten.

Die Erfindung wird nachfolgend anhand einiger in der Zeichnung dargestellter, bevorzugter Ausführungsbeispiele näher erläutert. Dabei zeigt:

Fig. 1 eine Prinzipdarstellung des eingangs erwähnten, bekannten Transversalfilters mit einem CCD-Schieberegister mit Paralleleingängen und einem Serienausgang,

Fig. 2 einen Querschnitt durch eine Teilschaltung von Fig. 1,

Fig. 3 ein Zeitdiagramm der für ein Transversalfilter nach den Figuren 1 und 2 erforderlichen Betriebsspannungen,

Fig. 4 ein erstes Ausführungsbeispiel der Erfindung,

Fig. 5 ein Zeitdiagramm der für ein Transversalfilter nach Fig. 4 erforderlichen Betriebsspannungen,

Fig. 6 ein zweites Ausführungsbeispiel der Erfindung,

Fig. 7 ein Zeitdiagramm der gemäß Fig. 6 benötigten Betriebsspannungen,

Fig. 8 ein drittes Ausführungsbeispiel der Erfindung,

Fig. 9 ein viertes Ausführungsbeispiel der Erfindung und

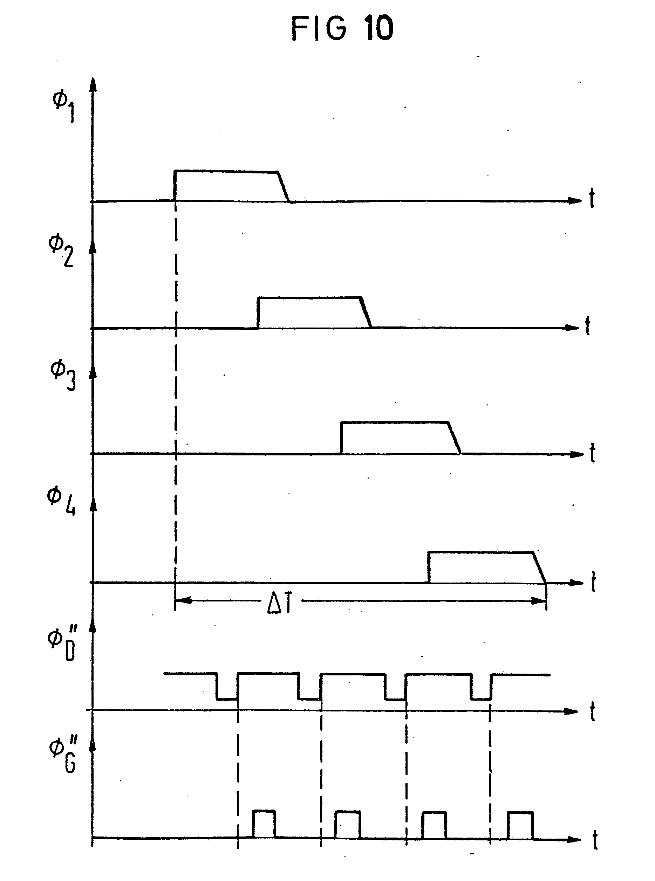

Fig. 10 ein Zeitdiagramm der für das vierte Ausführungsbeispiel erforderlichen Betriebsspannungen.

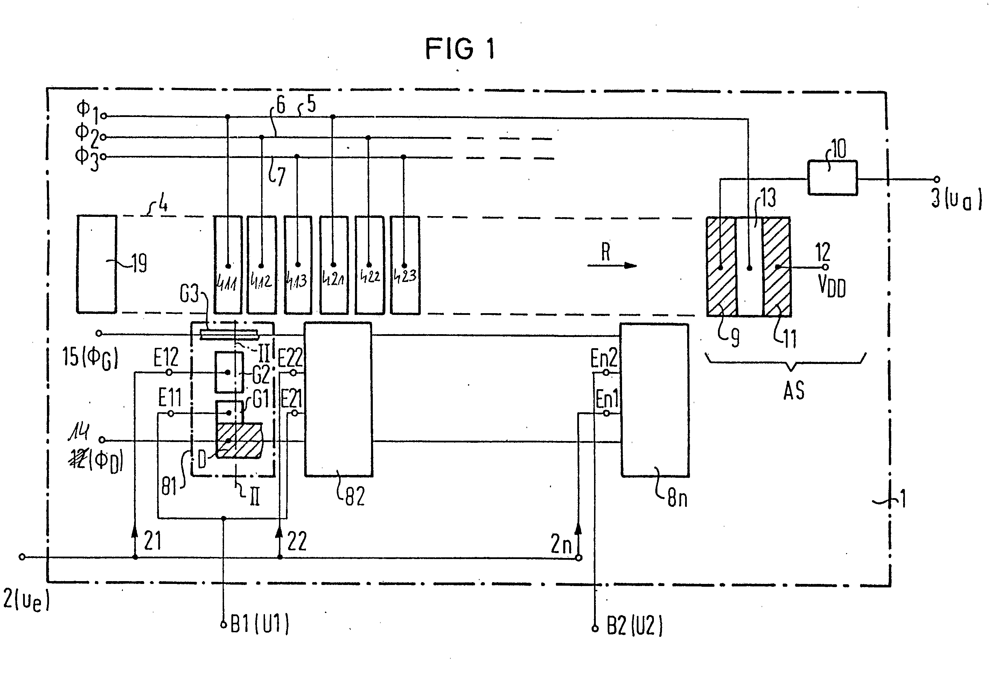

Das in Fig. 1 schematisch dargestellte Transversalfilter ist als eine auf einem dotierten Halbleitersubstrat 1, z.B. p-leitendem Silicium, monolithisch integrierte Halbleiterschaltung ausgebildet. Einem Anschluß 2 wird ein analoges Eingangssignal $u_e$ zugeführt, während am Ausgang 3 ein analoges Ausgangssignal $u_a$ abgreifbar ist, dessen zeitlicher Verlauf dem des Signals $u_e$ entspricht, nachdem dieses ein Frequenzfilter mit einer bestimmten Frequenzcharakteristik durchlaufen hat. Die Frequenzcharakteristik kann beispielsweise die eines Tiefpasses sein. Ein mit 4 bezeichnetes Schieberegister ist als eine ladungsgekoppelte Anordnung (CCD) ausgebildet und arbeitet im 3-Phasen-Betrieb. Sie weist eine Reihe von Elektroden 411, 412, 413, 421, 422, 423 usw. auf, die über einer das Substrat 1 abdeckenden, dünnen Isolierschicht, z.B. einer Gateoxidschicht aus $SiO_2$, dicht nebeneinanderliegend in Verschieberichtung R plaziert sind.

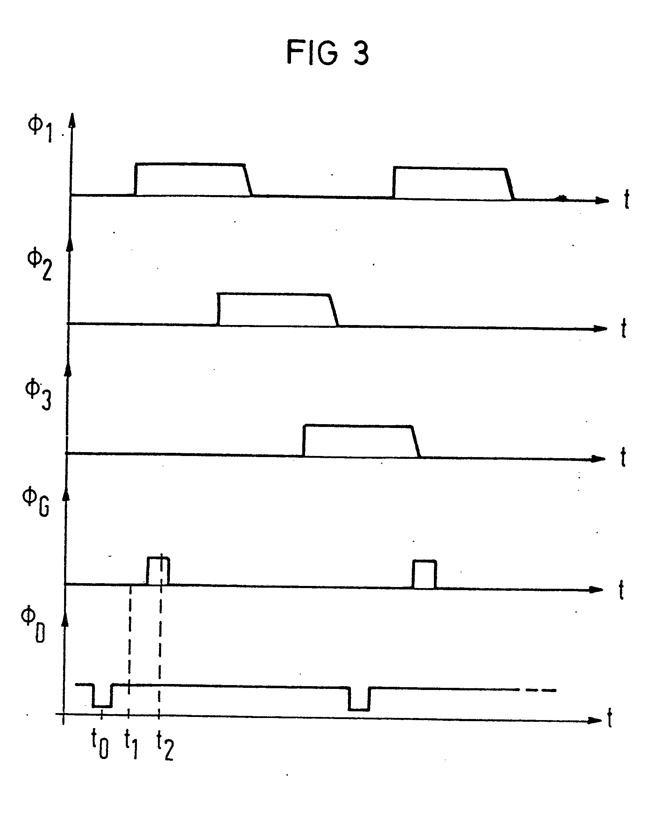

Jeweils drei nebeneinander liegende Elektroden, z.B. 411, 412 und 413 oder 421, 422 und 423, gehören zu einer Schieberegisterstufe, wobei die ersten Elektroden 411, 421 usw. sämtlicher Stufen an eine Leitung 5 angeschlossen und über diese mit einer Verschiebetaktspannung $\phi_1$ beschaltet sind, während die zweiten Elektroden 412, 422 usw. an einer gemeinsamen, mit einer Verschiebetaktspannung $\phi_2$ beschalteten Leitung 6 und die dritten Elektroden 413, 423 usw. an einer mit einer Verschiebetaktspannung $\phi_3$ beschalteten Leitung 7 liegen. Bei einem zeitlichen Verlauf der Spannungen $\phi_1$ bis $\phi_3$ gemäß Fig. 3 ergeben sich unterhalb jeder dritten Elektrode lokale Maxima des Oberflächenpotentials $\phi_s$ im Halbleitersubstrat 1, sogenannte Potentialtöpfe, die im Takte der Spannungen $\phi_1$ bis $\phi_3$ in Richtung R schrittweise von Stufe zu Stufe verschoben werden. Injiziert man nun in diese jeweils von Raumladungszonen umgebenen Potentialtöpfe elektrische Ladungen, die eine Polarität aufweisen, die der der Minoritätsladungsträger des Substrats 1 entspricht, so werden diese mit den Potentialtöpfen verschoben und können nach dem Durchlaufen des gesamten Schieberegisters 4 in dessen Ausgangsstufe AS zeitverzögert ausgelesen werden. Bei der in Fig. 1 dargestellten Ausführungsform des Schieberegisters 4 enthält die Ausgangsstufe AS ein zeitweilig von äußeren Potentialen freigeschaltetes Diffusionsgebiet 9 (floating diffusion output). Dieses ist über einen Ausgangsverstärker 10 mit dem Ausgang 3 leitend verbunden. Das Gebiet 9 stellt zusammen mit einem zweiten Diffusionsgebiet 11, das über einen Anschluß 12 mit einer Drainspannung $V_{DD}$ beschaltet ist, und einer Gateelektrode 13, die über die Leitung 5 an der Verschiebetaktspannung $\phi_1$ liegt, einen Feldeffekttransistor dar, der beim Auftreten der einzelnen Spannungsimpulse von $\phi_1$ das Gebiet 9 intermittierend auf ein Referenzpotential setzt.

Der Eingang 2 des Transversalfilters ist mit einer Reihe von Paralleleingängen 21, 22, 2n verbunden, die jeweils einzelnen Stufen des Schieberegisters 4 zugeordnet sind. Jeder dieser Paralleleingänge ist mit einer Bewertungsschaltung 81, 82, 8n versehen. Diese weisen jeweils ein entgegengesetzt zum Substrat 1 dotiertes Gebiet D, ein erstes Eingangsgate G1, ein zweites Eingangsgate G2 und ein Transfergate G3 auf, wobei die Gebiete D aller Bewertungsschaltungen 81 bis 8n zusammenhängend ausgebildet und mit einem Anschluß 14 verbunden sind, während die Transfergateelektroden G3 aller Bewertungsschaltungen ebenfalls zusammenhängend ausgebildet und mit einem Anschluß 15 versehen sind. Das erste Eingangsgate G1 der Bewertungsschaltungen 81 ist mit einem Anschluß E11 versehen, G2 mit einem Anschluß E12. Die entsprechenden Anschlüsse von 82 sind mit E21 und E22 bezeichnet, die der Bewertungsschaltung 8n mit En1 und En2. In Fig. 1 sind die Anschlüsse E11, E21 und En1 jeweils mit den Paralleleingängen 21, 22 und 2n verbunden, während die Anschlüsse E12 und E22 an einen gemeinsamen Anschluß B1 und der Anschluß En2 an einen Anschluß B2 geführt sind.

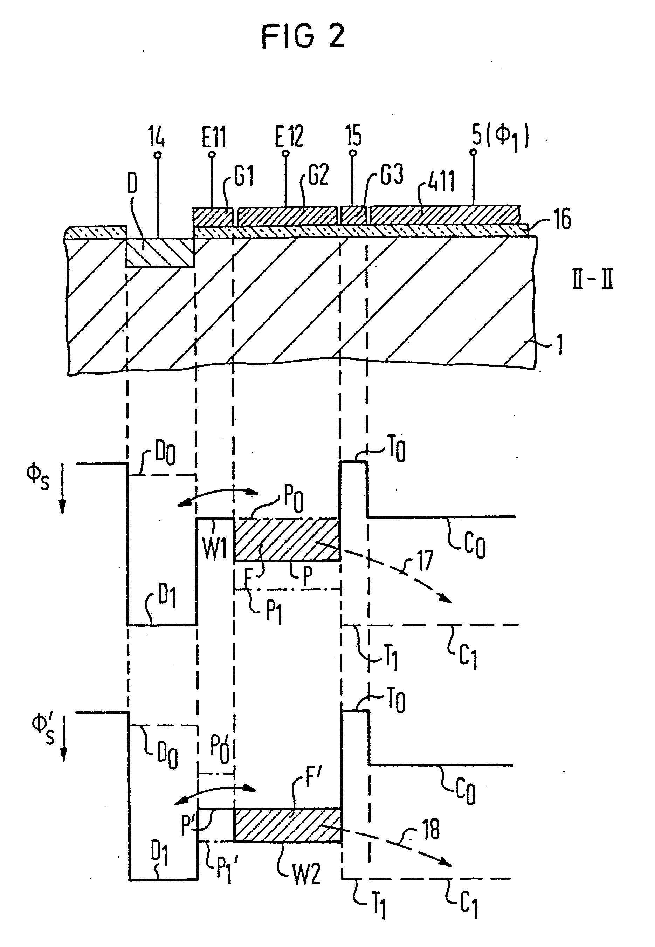

In Fig. 2 ist die Bewertungsschaltung 81 längs der Linie II—II geschnitten dargestellt. Dabei sind die bereits in Fig. 1 gezeigten Teile mit denselben Bezugszeichen versehen. Die dünne Isolierschicht, auf der die Teile G1, G2, G3 und 411 plaziert sind, ist mit 16 bezeichnet. Die Bewertungsschaltung 81 ist für einen positiven Bewertungskoeffizienten eingerichtet. Dabei wird dem Anschluß E11 des ersten Eingangsgate G1 über B1 eine konstante Gleichspannung U1 zugeführt, die höchstens so groß ist wie das kleinste zu bewertende Eingangssignal $u_e$, so daß sich für das Oberflächenpotential $\phi_s$ unterhalb von G1 eine feste Potentialschwelle W1 ergibt. Dem Anschluß E12 wird über den Paralleleingang 21 das Eingangssignal $u_e$ zugeführt, wobei sich unterhalb von G2 Potentialwerte zwischen $P_1$ (für das maximale Signal $u_e$) und $P_0$ (für das minimale Signal $u_e$) ergeben.

Unter dem Einfluß der in Fig. 3 dargestellten Taktspannungen $\phi_G$ und $\phi_D$, die jeweils den Anschlüssen 14 und 15 zugeführt werden, ergeben sich Potentialwerte $D_1$ bzw. $D_0$ und $T_1$ bzw. $T_0$ innerhalb des dotierten Gebiets D und unterhalb des Transfergate G3 gemäß Fig. 2. Zum Zeitpunkt $t_0$ (Fig. 3) besteht ein Potentialverlauf $D_0$, $W_1$, P, $T_0$ und $C_0$, wobei der Potentialwert P durch die Größe des auftretenden Eingangssignals $u_e$ gegeben ist. Dabei wird der unterhalb von G2 gebildete Potentialtopf mit Ladungsträgen überschwemmt. Zum Zeitpunkt $t_1$ ist $D_0$ in $D_1$ übergegangen, wobei die Ladungsträger wieder soweit aus dem Bereich unterhalb von G1 und G2 in das Gebiet D zurückfließen, daß der unterhalb von G2 gebildete Potentialtopf nur noch bis zu dem durch $W_1$ gegebenen Rand angefüllt bleibt, was in Fig. 2 durch die schraffierte Fläche F angedeutet ist. Ist dann $T_0$ in $T_1$ übergegangen (Zeitpunkt $t_2$) so wird die durch F angedeutete Ladungsmenge entsprechend dem Pfeil 17 unter die Elektrode 411 verschoben, da diese gleichzeitig mit einer relativ hohen Verschiebetaktspannung $\phi_1$ belegt ist, die einen Potentialwert $C_1$ ergibt. Wesentlich ist hierbei, daß bei einer Ausbildung der Schaltung 81 für einen positiven Bewertungskoeffizienten beim Auftreten des minimalen Eingangssignals $u_e$ wegen $P=P_0$ keine Ladungsmenge eingelesen wird, beim Auftreten des maximalen Eingangssignals $u_e$ wegen $P=P_1$ die maximale Ladungsmenge, die durch die zwischen den Werten $P_0$ and $P_1$ liegende Fläche dargestellt werden kann. Der Einlesevorgang wiederholt sich mit der Frequenz der Verschiebetaktspannung $\phi_1$.

Ist eine Bewertungsschaltung, z.B. die Schaltung 8n in Fig. 1, für einen negativen Bewertungskoeffizienten eingerichtet, so wird ihrem ersten Eingangsgate über den Anschluß En1 von einem Paralleleingang 2n das Eingangssignal $u_e$ zugeführt, während ihr zweites Eingangsgate über einen Anschluß En2 und einen Anschluß B2 nunmehr mit einer konstanten Gleichspannung U2 belegt ist, die wenigstens so groß ist wie das maximale zu bewertende Eingangssignal $u_e$ und unterhalb von G2 einen festen Potentialwert W2 ergibt. Unterhalb von G2 ergeben sich dann Potentialwerte $P_1'$ für das maximale Eingangssignal und $P_0'$ für das minimale Eingangssignal $u_e$. Das Anfüllen des Potentialtopfes unterhalb von G2 ist dabei nur bis zu dem durch das zum Zeitpunkt t1 anliegende Eingangssignal $u_e$ bestimmten Rand P' möglich, was in Fig. 2 durch die Fläche F' gekennzeichnet ist. Nach dem Übergang von $T_0$ auf $T_1$ und von $C_0$ auf $C_1$ (Zeitpunkt t2) wird die Ladungsmenge F' wieder unter eine Elektrode des CCD-Schieberegisters 4 verschoben (Pfeil 18). Wesentlich ist, daß bei einem negativen Bewertungskoeffizienten beim Auftreten des minimalen Eingangssignals $u_e$ wegen $P'=P_0'$ die maximale Ladungsmenge eingegeben wird, was in Fig. 2 durch eine Fläche unterhalb von G2 und zwischen den Potentialwerten $P_0'$ und $P_1'$ verdeutlicht wird, während für das maximale Eingangssignal $u_e$ wegen $P'=P_1'$ keine Ladungsmenge eingelesen wird. Auch dieser Einlesevorgang wiederholt sich mit der Frequenz der Verschiebetaktspannung $\phi_1$.

Somit finden in dem Schieberegister 4 unter den Elektroden 411, 421 usw. jeweils beim Auftreten der Verschiebetaktspannungen $\phi_1$ Summierungsvorgänge statt, bei denen zu den jeweils innerhalb des Schieberegisters 4 verschobenen Ladungsmengen die über die zugehörigen Paralleleingänge eingegebenen Ladungsmengen F bzw. F' addiert werden. Die auf diese Weise durch mehrfache Summierungsvorgänge angewachsenen Ladungsmengen, die schließlich in der letzten Stufe des Schieberegisters 4 nacheinander ankommen, bewirken dann beim Eindringen in das Diffusionsgebiet 9, das zuvor auf Referenzpotential gebracht wurde, jeweils Potentialverschiebungen, die über den Verstärker 10 ausgewertet und zu dem gefilterten Ausgangssignal $u_a$ zusammengesetzt werden.

Man kann durch einem mit 19 angedeutete, an sich bekannt Eingangsstufe des Schieberegisters 4, die beispielsweise in dem Buch von Sequin und Tompsett "Charge Transfer Devices", Academic Press, New York, 1975, auf den Seiten 48 bis 50, insbesondere Fig. 3.12 (d), beschrieben ist, zu den über das Schieberegister verschobenen Ladungsmengen eine konstante Grundladung hinzufügen, die in der Literatur auch als "fat zero" bezeichnet wird. Hierbei besteht das dieser Eingangsstufe zugeführte Signal aus einer Gleichspannung.

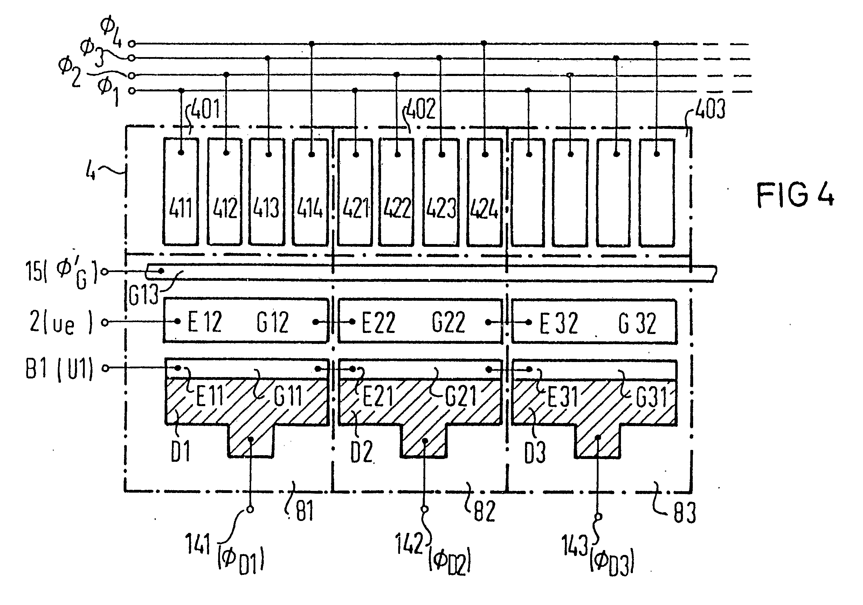

Bei dem in Fig. 4 schematisch dargestellten, nach der Erfindung ausgebildeten Transversalfilter ist das Schieberegister 4 als eine 4-Phasen-CCD-Anordnung ausgebildet. Die erste Stufe 401 weist die Verschiebeelektroden 411, 412, 413 und 414 auf, die zweite Stufe 402 die Elektroden 421, 422, 423 und 424. Die dritte Stufe des Schieberegisters ist mit 403 bezeichnet, weitere Stufen und die Ausgangsstufe, die entsprechend der Stufe AS in Fig. 1 aufgebaut sein kann, sind aus Gründen der Übersichtlichkeit nicht im Einzelnen dargestellt. Die den ersten Verschiebeelektroden sämtlicher Stufen zugeführte Taktspannung ist mit $\phi_1$ bezeichnet, während den zweiten, dritten und vierten Elektroden sämtlicher Stufen jeweils die Verschiebetaktspannungen $\phi_2$, $\phi_3$ und $\phi_4$ zugeleitet werden.

Den Stufen 401, 402 und 403 sind die Bewertungsschaltungen 81, 82 und 83 zugeordnet. Sie weisen nach der Erfindung jeweils voneinander isolierte, entgegengesetzt zu dem Halbleitersubstrat dotierte Gebiete D1, D2 und D3 auf, die mit eigenen Anschlüssen 141, 142 und 143 versehen und über diese mit ersten Taktspannungen $\phi_{D1}$, $\phi_{D2}$ und $\phi_{D3}$ beschaltet sind. Die ersten Eingangsgateelektroden der drei Bewertungsschaltungen sind mit G11, G21 und G31 bezeichnet, ihre Anschlüsse entsprechend Fig. 1 mit E11, E21 und E31. Die zweiten Eingangsgateelektroden G12, G22 und G32 weisen Anschlüsse E12, E22 und E32 auf. In der dargestellten ausführungsform sind die ersten und zweiten Eingangsgateelektroden aller Bewertungsschaltungen untereinander verbunden und mit gemeinsamen Anschlüssen B1 bzw. 2 ausgestattet. Ein gemeinsames Transfergate ist mit G13 bezeichnet und mit einem Anschluß 15 versehen. Beim Zuführen des Eingangssignals $u_e$ an den Anschluß 2 und einer konstanten Gleichspannung U1, die höchstens so groß ist wie das kleinste Signal $u_e$, an den Anschluß B1 sind die Bewertungsschaltungen 81 bis 83 jeweils für einen positiven Bewertungskoeffizienten eingerichtet. Legt man $u_e$ stattdessen an den Anschluß B1 und eine konstante Gleichspannung U2, die wenigstens so groß ist wie das größte Signal $u_e$, an den Anschluß 2, so ergeben sich nur negative Bewertungskoeffizienten. Will man einzelnen Bewertungskoeffizienten, z.B. dem der Schaltung 82, ein negatives Vorzeichen geben, so müssen die betreffenden Eingänge dieser Schaltung, im betrachteten Fall also E21 und E22, in Abweichung von Fig. 4 mit den Spannungen $u_e$ und U2 in der zuletzt beschriebenen Weise beschaltet werdan.

In Fig. 4 entspricht die Breite der ersten und zweiten Eingangsgateelektroden, z.B. G11 und G12, der Länge der zugeordneten Stufe des Schieberegisters 4, z.B. der Länge von 401. Hierdurch wird erreicht, daß während des gesamten Zeitintervalls $\Delta T$, in dem sich der durch die Verschiebetaktspannungen gebildete Potentialtopf unterhalb der Elektroden dieser Stufe befindet, aus der augehörigen Bewertungsschaltung Ladungsmengen eingelesen werden können. Ist die Breite der genannten Eingangsgateelektroden kleiner, so verringert sich $\Delta T$ entsprechend. Entspricht die Breite lediglich der Länge einer CCD-Elektrode, z.B. 411, so reduziert sich $\Delta T$ auf ein Viertel.

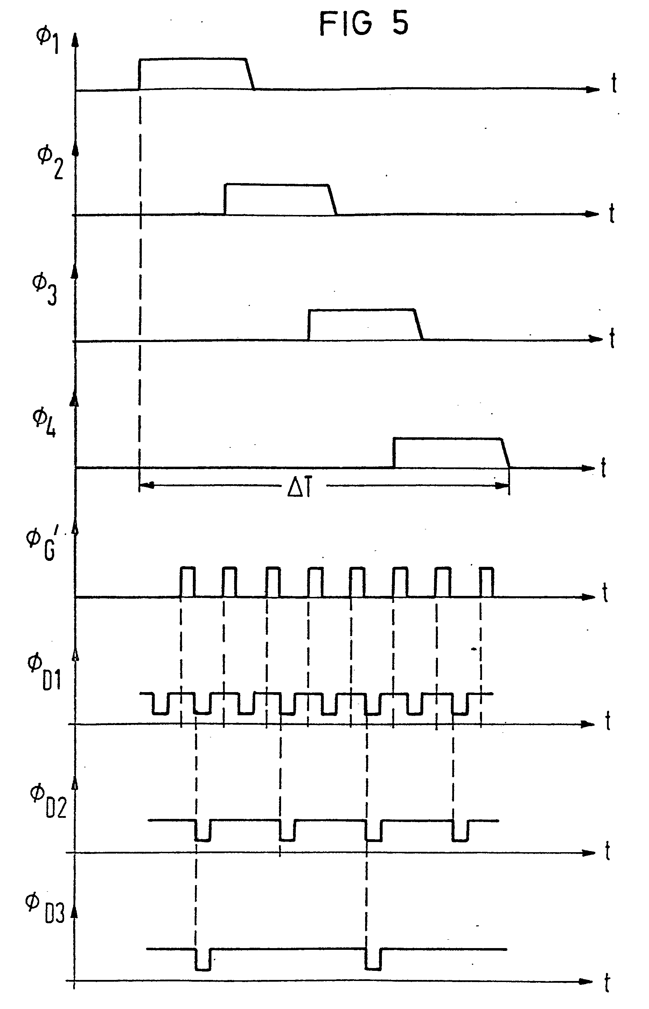

Fig 5 zeigt die Verschiebetaktspannungen des Schieberegisters sowie die ersten Taktspannungen $\phi_{D1}$, $\phi_{D2}$ und $\phi_{D2}$ und die zweite Taktspannung $\phi_G'$, die zum Betrieb der Schaltung nach Fig. 4 erforderlich sind. Innerhalb des Zeitintervalls $\Delta T$ treten hierbei acht Impulse von $\phi_{D1}$ auf, vier Impulse von $\phi_{D2}$ und zwei Impulse von $\phi_{D3}$. Dabei ist jedem Impuls von $\phi_{D1}$ ein zeitverzögert auftretender Impuls $\phi_G'$ zugeordnet. Gemäß Fig. 4 werden innerhalb von $\Delta T$ acht durch die Fläche von G12 bestimmt Ladungsmengen in die Stufe 401 eingelesen, vier durch die Fläche von G22 bestimmte Ladungsmengen in Stufe 402 und zwei durch G32 bestimmte Ladungsmengen in die Stufe 403, so daß sich die Bewertungskoeffizienten der Schaltungen 81, 82 und 83 wie 4:2:1 verhalten. Es können auch andere Folgefrequenzen der ersten Taktspannung herangezogen werden, die zueinander nicht im Verhältnis ganzer Zahlen stehen. Soll jedoch ein gemeinsames Transfergate G13 vorgesehen werden, so muß die zweite Taktspannung $\phi_G'$ für die Impulse aller ersten Taktspannungen, die zeitlich getrennt auftreten, einen zugeordneten, zeitlich verzögerten Impuls enthalten. Sieht man für die Bewertungsschaltungen getrennte Transfergateelektroden vor, so sind diesen jeweils zweite Taktspannungen zuzuführen, die sich zu den ersten Taktspannungen in dem anhand der Spannungen $\phi_G'$ und $\phi_{D1}$ in Fig. 5 erläuterten Verhältnis stehen.

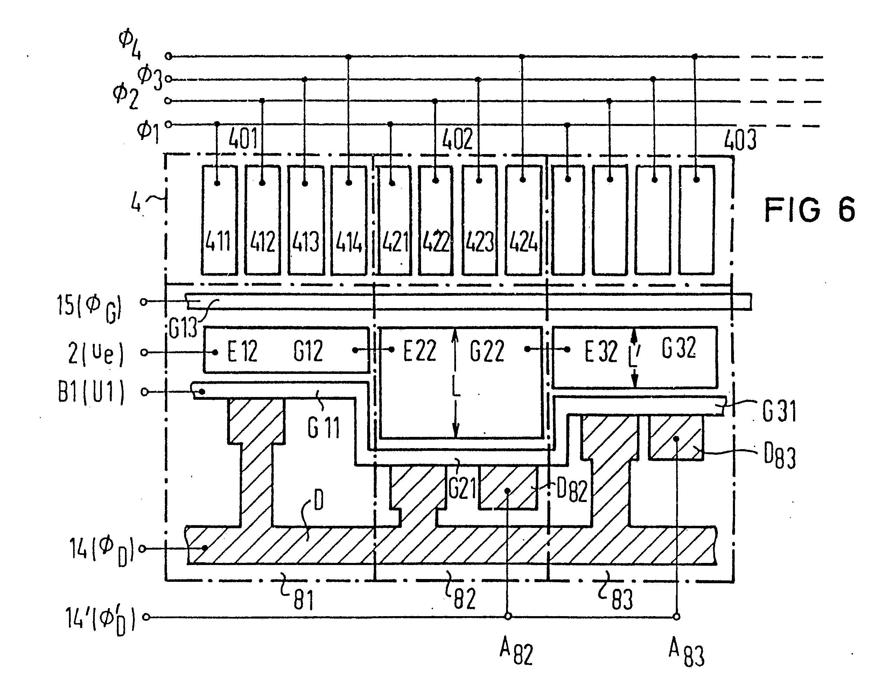

Bei dem in Fig. 6 schematisch dargestellten, nach der Erfindung ausgebildeten Transversalfilter sind den Stufen 401, 402 und 403 ebenso wie in Fig. 4 die Bewertungsschaltungen 81, 82 und 83 zugeordnet. Sie weisen in der hier dargestellten Ausführungsform ein gemeinsames, entgegengesetzt zum Substrat dotiertes Gebiet $D_g$ auf, das mit einem Anschluß 14 versehen ist. Die ersten Eingangsgateelektroden sind mit G11, G21 und G31 bezeichnet, die zweiten Eingangsgateelektroden mit G12, G22 und G32. In der dargestellten Ausführungsform sind die ersten und zweiten Eingangsgateelektroden der Bewertungsschaltungen 81 bis 83 untereinander verbunden und mit gemeinsamen Anschlüssen B1 bzw. 2 versehen. Ein allen Bewertungsschaltungen gemeinsames Transfergate ist mit G13 bezeichnet und mit einem Anschluß 15 versehen. Beim Zuführen des Eingangssignals $u_e$ an den Anschluß 2 und einer konstanten Gleichspannung U1, die höchstens so groß ist wie das kleinste Signal $u_e$, an den Anschluß B1, sind die Bewertungsschaltungen 81 und 83 jeweils für einen positiven Bewertungskoeffizienten eingerichtet. Legt man $u_e$ stattdessen an den Anschluß B1 und eine konstante Gleichspannung U2, die mindestens so groß ist wie das größte Signal $u_e$, an den Anschluß 2, so ergeben sich nur negative Bewertungskoeffizienten. Will man einzelnen Bewertungskoeffizienten, z.B. dem der Schaltung 82, ein negatives Vorzeichen geben, so müssen die betreffenden Eingangsgateelektroden dieser Schaltung, im betrachteten Fall also G21 und G22, in Abweichung von Fig. 6 von den übrigen Eingangsgateelektroden getrennt werden und mit den Spannungen $u_e$ und $U_2$ beschaltet werden, wobei $u_e$ an G21 und U2 an G22 gelegt wird.

Die Bewertungsstufe 82 weist nun ein zusätzliches, entgegengesetzt zum Substrat dotiertes Gebiet $D_{82}$ auf, das mit einem Anschluß $A_{82}$ verbunden ist. Ebenso ist in der Bewertungsstufe 83 ein zusätzliches Gebiet $D_{83}$ vorgesehen, das einen Anschluß $A_{83}$ aufweist. Die Anschlüsse $A_{82}$ und $A_{83}$ sind mit einem gemeinsamen Anschluß 14' verbunden.

In Fig. 6 entspricht die Breite der ersten und zweiten Eingangsgateelektroden, z.B. G11 und G12, der Länge der zugeordneten Stufe des Schieberegisters 4, z.B. der Länge von 401. Hierdurch wird erreicht, daß während des gesamten Zeitintervalls $\Delta T$, in dem sich der durch die Verschiebetaktspannungen gebildete Potentialtopf unterhalb der Elektroden dieser Stufe befindet, aus der zugehörigen Bewertungsschaltung Ladungsmengen eingelesen werden können. Ist die Breite der genannten Eingangsgateelektroden kleiner, so verringert sich $\Delta T$ entsprechend. Entspricht die Breite lediglich der Länge einer CCD-Elektrode, z.B. 411, so reduziert sich $\Delta T$ etwa auf ein Viertel.

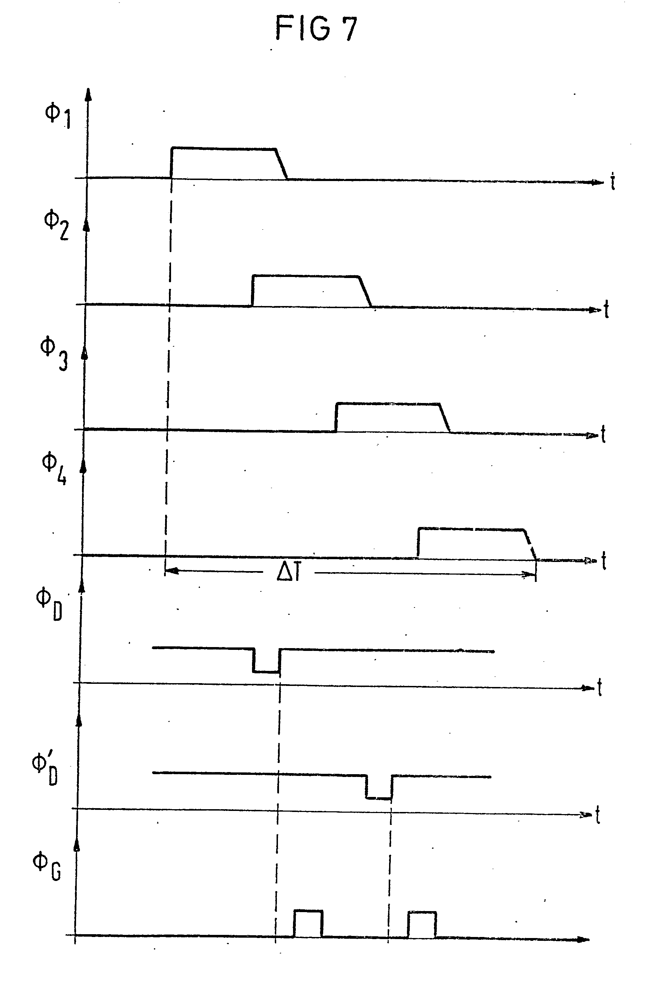

Fig. 7 zeigt die Verschiebetaktspannungen $\phi_1$ bis $\phi_4$ des Schieberegisters 4, sowie die den Bewertungsschaltungen 81 bis 83 zuzuführenden Taktspannungen in ihren zeitlichen Verlauf. Zu den letzteren gehört wieder eine erste Taktspannung $\phi_D$, die dem gemeinsamen Anschluß 14 zugeführt wird, und eine zweite Taktspannung $\phi_G$, die an den Anschluß 15 gelegt ist. Zusätzlich ist eine Taktspannung $\phi_D'$ vorgesehen, die aus der Spannung $\phi_D$ über ein Verzögerungsglied abgeleitet wird, wobei die Verzögerung so gewählt ist, daß jeweils ein Spannungsimpuls von jeder der Spannungen $\phi_D$ und $\phi_D'$ innerhalb des Zeitintervalles $\Delta T$ liegt. Das bedeutet, daß innerhalb von $\Delta T$ nur eine durch die Fläche von G12 bestimmte Ladungsmenge in die Stufe 401 eingelesen wird, während im gleichen Zeitraum zwei durch G22 bestimmte Ladungsmengen in 402 und zwei durch G32 bestimmte Ladungsmengen in 403 eingelesen werden.

Durch die zusätzliche Ansteuerung der Schaltung mittels $\phi_D'$ gelingt es, die Beträge der in den Schaltungen 82 und 83 gebildeten Bewertungskoeffizienten gegenüber den durch die Gateflächen bestimmten Werten ohne zusätzlichen Flächenaufwand zu verdoppeln. Würde diese Verdoppelung durch eine entsprechende Vergrößerung der Gateflächen von G22 und G32 erzielt werden, was bei dem in Fig. 6 dargestellten Beispiel nur durch eine Vergrößerung der Längen L und L' möglich wäre, so würden die Einlesevorgänge auch wesentlich längere Einlesezeiten beanspruchen, was den Arbeitsfrequenzbereich des Transversalfilters nach oben begrenzen würde.

Die dem Transfergate G13 in Fig. 6 zuge-

führte zweite Taktspannung $\phi_G$ muß für jeden der zeitlich getrennt auftretenden Impulse der ersten Taktspannungen $\phi_D$ und $\phi_D'$ einen verzögerten Impuls aufweisen. Das wird in einfacher Weise dadurch erreicht, daß $\phi_G$ aus der Summenspannung von $\phi_D$ und $\phi_D'$ über einen Inverter und ein Verzögerungsglied abgeleitet wird.

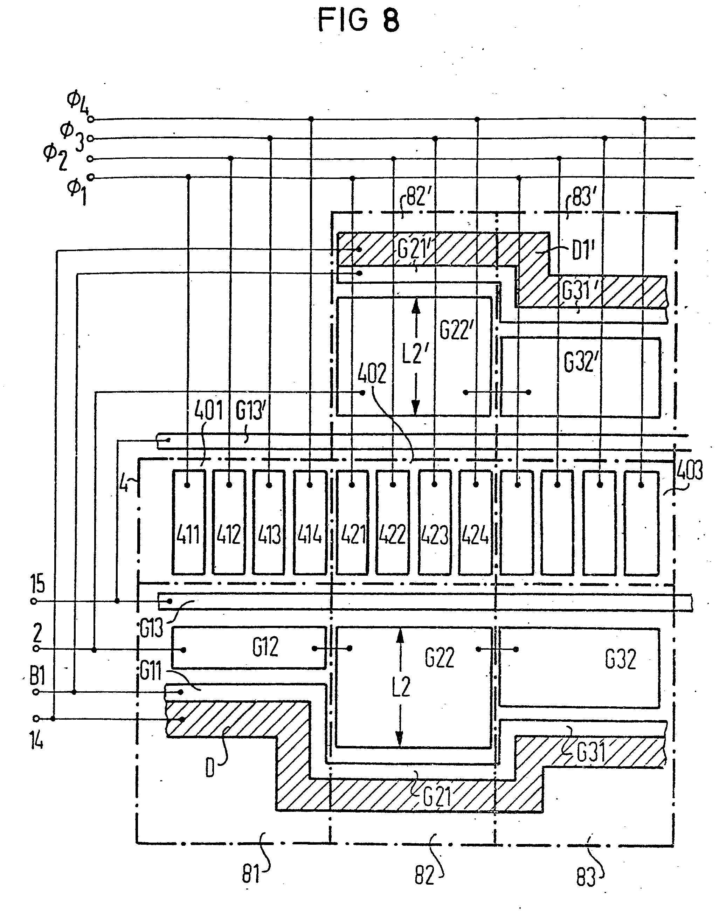

Bei dem in Fig. 8 dargestellten Ausführungsbeispiel der Erfindung sind den Stufen 401, 402 und 403 entsprechend den Figuren 4 und 6 wieder die Bewertungsschaltungen 81, 82 und 83 zugeordnet. Sie weisen ein gemeinsames, entgegengesetzt zum Substrat dotiertes Gebiet D auf, das mit einem Anschluß 14 versehen ist. Die ersten Eingangselektroden sind mit G11, G21 und G31 bezeichnet, die zweiten Eingangsgateelektroden mit G12, G22 und G32. Die ersten und zweiten Eingangsgateelektroden der Bewertungsschaltungen 81 bis 83 sind untereinander verbunden und mit gemeinsamen Anschlüssen B1 bzw. 2 versehen. Ein allen Bewertungsschaltungen gemeinsames Transfergate ist mit G13 bezeichnet und mit einem Anschluß 15 versehen. Beim Zuführen des Eingangssignals $u_e$ an den Anschluß 2 und einer konstanten Gleichspannung U1, die höchstens so groß ist wie das kleinste Signal $u_e$, an den Anschluß B1, sind die Bewertungsschaltungen 81 bis 83 jeweils für einen positiven Bewertungskoeffizienten eingerichtet. Legt man $u_e$ stattdessen an den Anschluß B1 und eine konstante Gleichspannung U2, die mindestens so groß ist wie das größte Signal $u_e$, an den Anschluß 2, so ergeben sich nur negative Bewertungskoeffizienten. Will man einzelnen Bewertungskoeffizienten, z.B. dem der Schaltung 82, ein negatives Vorzeichen geben, so müssen die betreffenden Eingangsgateelektroden dieser Schaltung, im betrachteten Fall also G21 und G22, in Abweichung von Fig. 8 von den übrigen Eingangsgateelektroden getrennt werden und mit den Spannungen $u_e$ und U2 beschaltet werden, wobei $u_e$ an G21 und U2 an G22 gelegt wird.

In Fig. 8 sind weitere Bewertungsschaltungen 82' und 83' vorgesehen, wobei jeweils die Schaltungen 82 und 82' sowie die Schaltungen 83 und 83' zu der Mittellinie des Transferkanals des Schieberegisters 4 symmetrisch liegen. Die Bewertungsschaltungen 82' und 83' besitzen ein gemeinsames, entgegengesetzt zum Substrat dotiertes Gebiet D1', das mit dem Anschluß 14 verbunden ist. Ihre ersten Eingangsgateelektroden G21' und G31' sind mit dem Anschluß B1 verbunden, ihre zweiten Eingangsgateelektroden G22' und G32' mit dem Anschluß 2. Weiterhin weisen sie ein gemeinsames, als G13' bezeichnetes Transfergate auf, das mit dem Anschluß 14 verbunden ist. Wegen der gemeinsamen Ansteuerung sind jeweils die an der gleichen Stufe des CCD-Schieberegisters einander gegenüberliegenden Bewertungsschaltungen, also 82 und 82' bzw. 83 und 83', für das gleiche Vorzeichen des Bewertungskoeffizienten eingerichtet. Mit dem Eingangssignal $u_e$ an 2 und der Spannung U1 an B1 ist das Vorzeichen positiv, für $u_e$ an B1 und U2 an 2 ist es negativ. Soll der Bewertungskoeffizienten einer der Schaltungen 81 bis 83, z.B. der der Schaltung 82, ein negatives Vorzeichen erhalten, während die übrigen Stufen, z.B. 81 und 83, für positive Vorzeichen eingerichtet sind, so müssen auch das erste und zweite Eingangsgate der dieser gegenüberliegenden Schaltung, also der Schaltung 82', von der Eingangsgateelektroden der Bewertungsschaltung 83' getrennt und entsprechend der Schaltung 82 in der bereits beschriebenen Weise mittels $U_e$ und U2 angesteuert werden.

Infolge der gleichartigen Ansteuerung der jeweils einander gegenüberliegenden Bewertungsschaltungen wird in die Stufe 402 eine Ladungsmenge eingelesen, die der Summe der Flächen der Eingangsgateelektroden G22 und G22' proportional ist, während in die Stufe 403 eine der Summe der Flächen von G32 und G32' proportionale Ladungsmenge eingelesen wird. Da die Eingangsgateelektroden G22 und G22' gleich breit bemessen sind, entspricht die in 402 eingelesene Ladungsmenge der Summe der Längen dieser Elektroden, also der Summe L2+L2'. Würde die Schaltung 82' fehlen, so müßte G22 zum Einlesen derselben Ladungsmenge in die Stufe 402 mit einer Länge ausgebildet werden, die L2+L2' entspricht. Da aber die Einlesezeit der Ladungsmenge etwa dem Quadrat der Länge der zweiten Eingangsgateelektrode proportional ist, würde das eine wesentliche Vergrößerung der Einlesezeit bedeuten. Somit erlaubt die Anordnung zweier einander gegenüberliegender Bewertungsschaltungen das Einlesen einer vorgegebenen Ladungsmenge in einer wesentlich kürzeren Einlesezeit, als dies bei einer einzigen Bewertungsschaltung der Fall wäre, die zum Einlesen dieser Ladungsmenge eingerichtet wäre. Sind die Elektrodenlängen L und L' gleich groß, so reduziert sich die Einlesezeit durch die genannten Maßnahmen etwa auf ein Viertel.

Obwohl das Schieberegister 4 bisher lediglich als eine CCD-Anordnung beschrieben wurde, kann es aus irgendeiner der unter dem Begriff Ladungsverschiebeanordnung (CTD, Charge Transfer Device) zusammengefaßten, an sich bekannten Anordnungen bestehen, wie sie beispielsweise in dem Buch von Sequin und Tompsett "Charge Transfer Devices", Academic Press, New York, 1975, Seiten 1 bis 18, beschrieben sind. Eine solche Ladungsverschiebeanordnung kann dabei entsprechend ihrem Aufbau z.B. im Zwei-Phasen-, Drei-Phasen- oder Vier-Phasen-Betrieb arbeiten.

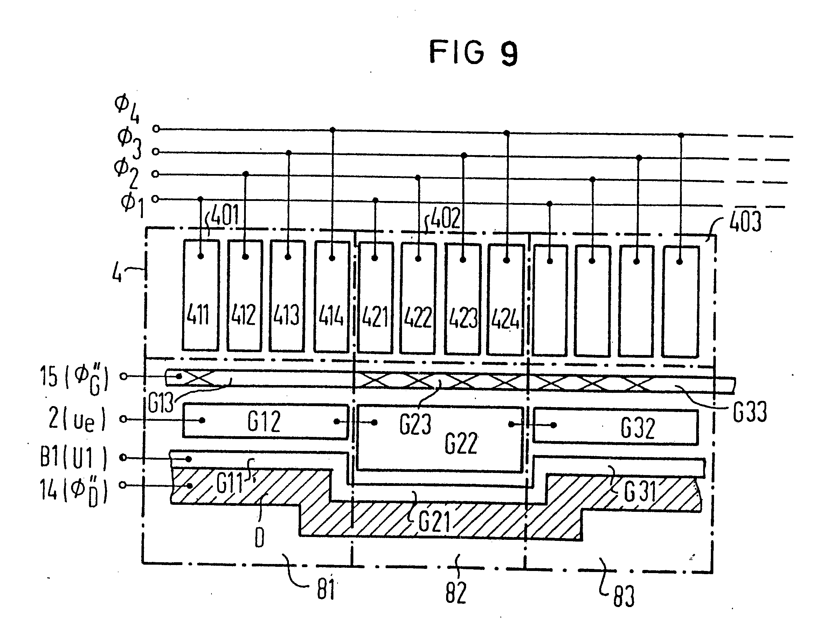

In Fig. 9 ist ein weiteres Ausführungsbeispiel der Erfindung dargestellt, bei dem den Stufen 401, 402 und 403 die Bewertungsschaltungen 81, 82 und 83 zugeordnet sind. Sie weisen wieder ein gemeinsames, entgegengesetzt zum Substrat dotiertes Gebiet D auf, das mit einem Anschluß 14 versehen ist. Die ersten Eingangsgateelektroden sind mit G11, G21 und G31 bezeichnet, die zweiten Eingangsgateelektroden mit G12, G22 und G32. In der hier dargestellten Ausführungsform sind die ersten und zweiten Eingangsgateelektroden der Bewertungsschaltungen 81 bis 83 untereinander verbunden und mit gemeinsamen Anschlüssen B1 bzw. 2 versehen. Ein allen Bewertungsschaltungen gemeinsames Transfergate ist in seinen den Schaltungen 81, 82 und 83 zugeordneten Abschnitten mit G13, G23 und G33 bezeichnet und mit einem Anschluß 15 versehen. Beim Zuführen des Eingangssignals $u_e$ an den Anschluß 2 und einer konstanten Gleichspannung U1, die höchstens so groß ist wie das kleinste Signal $u_e$, an den Anschluß B1, sind die Bewertungsschaltungen 81 bis 83 jeweils für einen positiven Bewertungskoeffizienten eingerichtet. Legt man $u_e$ stattdessen an den Anschluß B1 und eine konstante Gleichspannung U2, die mindestens so groß ist wie das größte Signal $u_e$, an den Anschluß 2, so ergeben sich nur negative Bewertungskoeffizienten. Will man einzelnen Bewertungskoeffizienten, z.B. dem der Schaltung 82, ein negatives Vorzeichen geben, so müssen die betreffenden Eingangsgateelektroden dieser Schaltung, im betrachteten Fall also G21 und G22, in Abweichung von Figur 4 von den übrigen Eingangsgateelektroden getrennt werden und mit den Spannungen $u_e$ und U2 beschaltet werden, wobei $u_e$ an G21 und U2 an G22 gelegt wird.

In Figur 9 entspricht die Breite der ersten und zweiten Eingangsgateelektroden einer Bewertungsschaltung, z.B. G11 und G12, der Länge der zugeordneten Stufe des Schieberegisters 4, z.B. der Länge von 401. Hierdurch wird erreicht, daß die Bewertungsschaltung während des gesamten Zeitintervalls ΔT, in dem sich der durch die Verschiebetaktspannungen gebildete Potentialtopf unterhalb der Elektroden dieser Stufe befindet, für das Einlesen von Ladungsmengen vorbereitet ist. Dem Anschluß 14 wird eine erste Taktspannung $\phi_D'$ und dem Anschluß 15 eine zweite Taktspannung $\phi_G'$ (Fig. 5) zugeführt, deren Impulsfolgefrequenz der vierfachen Impulsfolgefrequenz einer der Schiebetaktspannungen $\phi_1$ bis $\phi_4$ entsprechen. Damit ist die betrachtete Bewertungsschaltung im einzelnen so vorbereitet, daß in die zugehörige Stufe des Schieberegisters, z.B. 401, eine durch die Fläche des zweiten Eingangsgate, z.B. G12, bestimmte Ladungsmenge innerhalb der Zeit ΔT viermal eingelesen wird und zwar jeweils dann, wenn der durch die Verschiebetaktspannungen gebildete Potentialtopf sich unter einer der vier Elektroden dieser Stufe befindet.

Nach der Erfindung werden Maßnahmen getroffen, daß von diesen vorbereiteten Ladungseingaben nur eine ganz bestimmte Anzahl tatsächlich erfolgt. Dies geschieht in der Weise, daß unterhalb des zu der betreffenden Stufe des Schieberegisters 4 gehörenden Abschnittes der Transfergateelektrode, z.B. unterhalb von G13, nur innerhalb eines ganz bestimmten Teilabschnittes ein Dünnschichtbereich (Gateoxidbereich) der die Oberfläche des Halbleitersubstrats abdeckenden Isolierschicht, z.B. aus $SiO_2$, vorgesehen ist, während unterhalb der übrigen Teilabschnitte von G13 ein Dickschichtbereich (Feldoxidbereich) vorhanden ist. Unterhalb von G23 sind in Fig. 9 ausschließlich Dünnschichtbereiche vorgesehen, während unterhalb von G33 drei Dünnschichtbereich neben den ersten drei Elektroden der Stufe 403 und neben der vierten Elektrode ein Dickschichtbereich vorgesehen ist. Damit erfolgen während des Zeitintervalls ΔT eine Ladungseingabe in die Stufe 401, vier Ladungseingaben in die Stufe 402 und drei Ladungseingaben in die Stufe 403. Für 402 und drei Ladungseingaben in die Stufe 403. Für die Stufe 401 ergibt sich somit ein Bewertungskoeffizient, der der Fläche von G12 proportional ist, für die Stufe 402 ein solcher, der der vierfachen Fläche von G22 proportional ist und für die Stufe 403 ein Koeffizient, der der dreifachen Fläche von G32 entspricht.

Allgemein wird bei einer Ausbildung des Schieberegisters mit n Elektroden pro Stufe die Impulsfolgefrequenz der ersten und zweiten Taktspannung $\phi_D'$ und $\phi_G'$ so gewählt, daß sie dem n-fachen Wert der Impulsfolgefrequenz einer der Verschiebetaktspannungen $\phi_1$ bis $\phi_n$ entspricht, wobei durch die Anordnung der Dünnschichtbereich und Dickschichtbereiche der Isolierschicht unterhalb der Transfergateelektroden der einzelnen Bewertungsschaltungen eine Auswahl getroffen wird, ob jeweils die durch die Flächen der zweiten Eingangsgateelektroden bestimmten Ladungsmengen einfach, mehrfach bis maximal n-fach oder überhaupt nicht eingelesen werden sollen. Letzteres ist der Fall, wenn unterhalb des Transfergate einer Bewertungsschaltung nur Dickschichtbereiche der Isolierschicht vorgesehen sind.

Das Transversalfilter nach der Erfindung ist mit Vorteil als eine auf einem Halbleitersubstrat monolithisch integrierte Halbleiterschaltung aufgebaut. Dabei können in Fig. 4 die Flächen der zweiten Eingangsgateelektroden G12, G22 und G32 beispielsweise gleich groß gewählt werden, um eine besonders einfache Ausführungsform zu erhalten. Andererseits können in Fig. 4 auch Teile der die Taktspannungen $\phi_{D1}$, $\phi_{D2}$ und $\phi_{D3}$ und $\phi_G'$ liefernden Schaltungen in die Integration einbezogen werden. In Fig. 6 kann die elektrische Verbindung zwischen dem Anschluß 14' und den Anschlüssen $A_{82}$ und $A_{83}$ als ein kanalförmiges, entgegengesetzt zu dem Substrat dotiertes Halbleitergebiet ausgebildet sein. Die Verbindungen von den Anschlüssen $A_{82}$ und $A_{83}$ zu den Gebieten $D_{82}$ und $D_{83}$ können durch Leiterbahnen realisiert werden, die in der Ebene der Gateelektroden liegen.

Wird die Schaltung nach Fig. 8 als monolithisch integrierte Halbleiterschaltung in einer Technik mit Mehrlagenmetallisierung realisiert, so können die elektrischen Verbindungen zwischen den einzelnen Verschiebeelektroden des Schieberegisters 4 und den Zuführungen der Schiebetaktspannungen als Leiterbahnen ausgebildet sein, die von den Verbindungen der verschiedenen Elektroden der Bewertungsschaltungen mit den Anschlüssen 2, 14, 15 und B1 durch eine isolierende Zwischenschicht getrennt sind.

**Patentansprüche**

1. Transversalfilter, bei dem die Stufen eines auf einem dotierten Halbleitersubstrat integrierten, analogen CTD-Schieberegisters mit Paralleleingängen und diesen zugeordneten Bewertungschaltungen versehen sind, bei dem die Bewertungsschaltungen jeweils ein entgegengesetzt zu dem Substrat dotiertes Gebiet, ein erstes und zweites Eingangsgate und ein Transfergate aufweisen, wobei das Transfergate unmittelbar neben dem Transferkanal des CTD-Schieberegisters angeordnet ist, das eine Eingangsgate mit einem Eingangssignal, das andere Eingangsgate mit einer konstanten Gleichspannung, das entgegengesetzt dotierte Gebiet mit einer ersten und das Transfergate mit einer zweiten Taktspannungen beschaltet sind, und bei dem das Ausgangssignal an einem Ausgang des CTD-Schieberegisters abgreifbar ist, dadurch gekennzeichnet, daß die entgegengesetzt zu dem Halbleitersubstrat dotierten Gebiete (D1, D2, D3) der Bewertungsschaltungen (81, 82, 83) jeweils voneinander getrennt und mit eigenen Anschlüssen (141, 142, 143) versehen sind, die mit den einzelnen Bewertungsschaltungen individuell zugeordneten, ersten Taktspannungen $(\phi_{D1}, \phi_{D2}, \phi_{D3})$ beschaltet sind, und daß die Impulsfolgefrequenzen der ersten Taktspannungen $(\phi_{D1}, \phi_{D2}, \phi_{D3}$ höher liegen als die Impulsfolgefrequenz einer Verschiebetaktspannung $(\phi_1)$ des CTD-Schieberegisters (4) und so gewählt sind, daß sie jeweils die Größe der einzelnen Bewertungskoeffizienten bestimmen.

2. Transversalfilter nach Anspruch 1, dadurch gekennzeichnet, daß die zweiten Eingangsgateelektroden (G12, G22, G32) der Bewertungsschaltungen (81, 82, 83) untereinander flächengleich ausgebildet sind.

3. Transversalfilter, bei dem die Stufen eines auf einem dotierten Halbleitersubstrat integrierten, analogen CTD-Schieberegisters mit Paralleleingängen und diesen zugeordneten Bewertungsschaltungen versehen sind, bei dem die Bewertungsschaltungen jeweils ein entgegengesetzt zu dem Substrat dotiertes Gebiet, ein erstes und zweites Eingangsgate und ein Transfergate aufweisen, wobei das Transfergate unmittelbar neben dem Transferkanal des CTD-Schieberegisters angeordnet ist, das eine Eingangsgate mit einem Eingangssignal, das andere Eingangsgate mit einer konstanten Gleichspannung, das entgegengesetzt dotierte Gebiet mit einer ersten und das Transfergate mit einer zweiten Taktspannung beschaltet sind, und bei dem das Ausgangssignal an einem Ausgang des CTD-Schieberegisters abgreifbar ist, dadurch gekennzeichnet, daß eine oder mehrere Bewertungsschaltungen (82, 83) mit zusätzlichen, entgegengesetzt zum Substrat dotierten Gebieten $(D_{82}, D_{83})$ versehen sind, die mit einer zusätzlichen ersten Taktspannung $(\phi_D')$ beschaltet sind, welche gegenüber der den übrigen entgegengesetzt zum Substrat dotierten Gebieten $(D_g)$ der Bewertungsschaltungen (81 bis 83) zugeführten ersten Taktspannung $(\phi_D)$ phasenverschoben ist.

4. Transversalfilter nach Anspruch 3, dadurch gekennzeichnet, daß gegen die Substratoberfläche isolierte Leiterbahnen vorgesehen sind, die zur Zuführung der zusätzlichen ersten Taktspannung $(\phi_D')$ an die zusätzlichen, entgegengesetzt zum Substrat dotierten Gebiete $(D_{82}, D_{83})$ der Bewertungsschaltungen (82, 83) dienen.

5. Transversalfilter, bei dem die Stufen eines auf einem dotierten Halbleitersubstrat integrierten, analogen CTD-Schieberegisters mit Paralleleingängen und diesen zugeordneten Bewertungsschaltungen versehen sind, bei dem die Bewertungsschaltungen jeweils ein entgegengesetzt zu dem Substrat dotiertes Gebiet, ein erstes und zweites Eingangsgate und ein Transfergate aufweisen, wobei das Transfergate unmittelbar neben dem Transferkanal des CTD-Schieberegisters angeordnet ist, das eine Eingangsgate mit einem Eingangssignal, das andere Eingangsgate mit einer konstanten Gleichspannung, das entgegengesetzt dotierte Gebiet mit einer ersten und das Transfergate mit einer zweiten Taktspannung beschaltet sind, und bei dem das Ausgangssignal an einem Ausgang des CTD-Schieberegisters abgreifbar ist, dadurch gekennzeichnet, daß eine Bewertungsschaltung (82) durch eine auf der gegenüberliegenden Seite des Transferkanals angeordnete, weitere Bewertungsschaltung (82') zu einem Bewertungsschaltungspaar ergänzt ist, wobei die entgegengesetzt dotierten Gebiete (D, D1'), die Eingangsgateelektroden (G21, G22, G21', G22') und die Transfergateelektroden (G13, G13') beider Bewertungsschaltungen (82, 82') jeweils mit gemeinsamen Anschlüssen (14, 15, 2, B1) verbunden sind, die mit der ersten Taktspannung, dem Eingangssignal, der konstanten Gleichspannung und der zweiten Taktspannung beschaltet sind.

6. Transversalfilter nach Anspruch 5, dadurch gekennzeichnet, daß mehrere Bewertungsschaltungen (82, 83) jeweils zu einem Bewertungsschaltungspaar (82, 82'; 83, 83') ergänzt sind.

7. Transversalfilter, bei dem die Stufen eines auf einem dotierten Halbleitersubstrat integrierten, analogen CTD-Schieberegisters mit Paralleleingängen und diesen zugeordneten Bewertungschaltungen versehen sind, bei dem die Bewertungsschaltungen jeweils ein entgegengesetzt zu dem Substrat dotiertes Gebiet, ein erstes und ein zweites Eingangsgate und ein Transfergate aufweisen, wobei das Transfergate unmittelbar neben dem Transferkanal des CTD-Schieberegisters angeordnet ist, das eine Eingangsgate mit einer konstanten Gleichspannung, das entgegengesetzt dotierte Gebiet mit einer ersten und das Transfergate mit einer zweiten Taktspannung beschaltet sind und bei dem das Ausgangssignal an einem Ausgang des CTD-Schieberegisters abgreifbar ist, dadurch gekennzeichnet, daß unterhalb der Transfergateelektroden (G13) der einzelnen Bewertungsschaltungen (81) jeweils im Bereich einer vorgegebenen Anzahl von Verschiebeelektroden (411) der zugehörigen Stufen (401) des Schieberegisters (4) ein Dünnschichtbereich der die Oberfläche des Halbleitersubstrats abdeckenden Isolierschicht vorgesehen ist, während im Bereich der übrigen Verschiebeelektroden (412 bis 414) der jeweiligen Stufen (401) unterhalb der Transfergateelektrode (G13) Dickschichtbereiche der Isolierschicht vorhanden sind, und daß die Anzahl der Dünnschichtbereiche unterhalb der Transfergateelektroden der einzelnen Bewertungsschaltungen (81 bis 83) die in diesen gebildeten Beträge der Bewertungskoeffizienten mitbestimmten.

8. Transversalfilter nach einem der Ansprüche 1, 3, 5 oder 7, dadurch gekennzeichnet, daß die Breite der zweiten Eingangsgateelektroden (G12) der Bewertungsschaltungen (81) der Länge einer Stufe (401) des CTD-Schieberegisters (4) entspricht.

9. Transversalfilter nach einem der Ansprüche 1, 3, 5 oder 7, dadurch gekennzeichnet, daß es als eine auf einem Halbleitersubstrat monolithisch integrierte Halbleiterschaltung ausgebildet ist.

## Claims

1. A transversal filter wherein the stages of an analogue CTD shift register integrated on a doped semiconductor substrate are provided with parallel inputs and evaluation circuits assigned to said inputs, each evaluation circuit having a zone doped oppositely to the substrate, a first input gate, a second input gate and a transfer gate, the transfer gate being arranged immediately beside the transfer channel of the CTD shift register, the first input gate connected to an input signal, the other input gate connected to a constant direct voltage, the oppositely doped zone connected to a first clock pulse train voltage and the transfer gate to a second clock pulse train voltage, and wherein the output signal can be tapped from an output of the CTD shift register, characterised in that those zones (D1, D2, D3) of the evaluation circuits (81, 82, 83) which are doped oppositely to the semiconductor substrate are each separate from one another and are provided with their own terminals (141, 142, 143) which are connected to first clock pulse train voltages ($\phi_{D1}$, $\phi_{D2}$, $\phi_{D3}$) which are individually assigned to the individual evaluation circuits, and that the pulse repetition frequencies of the first clock pulse train voltages ($\phi_{D1}$, $\phi_{D2}$, $\phi_{D3}$) are higher than the pulse repetition frequency of a shift clock pulse train voltage ($\phi_1$) of the CTD shift register (4) and are selected to be such that they each determine the value of the individual evaluation coefficients.

2. A transversal filter as claimed in claim 1, characterised in that the second input gate electrodes (G12, G22, G32) of the evaluation circuits (81, 82, 83) are mutually equal in surface area.

3. A transversal filter wherein the stages of an analogue CTD shift register integrated on a doped semiconductor substrate are provided with parallel inputs and with evaluation circuits assigned to said inputs, wherein the evaluation circuits each possess a zone which is oppositely doped to the substrate, a first input gate, a second input gate and a transfer gate, the transfer gate being arranged directly beside the transfer channel of the CTD shift register, the first input gate connected to an input signal, the other input gate to a constant direct voltage, the oppositely doped zone to a first clock pulse train voltage, and the transfer gate to a second clock pulse train voltage, and wherein the output signal can be tapped from an output of the CTD shift register, characterised in that one or more evaluation circuit (82, 83) is/are provided with additional zones ($D_{82}$, $D_{83}$) which are oppositely doped to the substrate and which are connected to an additional first clock pulse train voltage ($\phi_D'$) displaced in phase relative to the first clock pulse train voltage ($\phi_D$) supplied to the other zones ($D_g$) of the evaluation circuits (81 to 83), which are oppositely doped to the substrate.

4. A transversal filter as claimed in claim 3, characterised in that conductor paths are provided which are insulated from the substrate surface and which serve to supply the additional first clock pulse train voltage ($\phi_D'$) to the additional zones ($D_{82}$, $D_{83}$), of the evaluation circuits (82, 83) which are oppositely doped to the substrate.

5. A transversal filter, wherein the stages of an analogue CTD shift register integrated on a doped semiconductor substrate are provided with parallel inputs and with evaluation circuits assigned to said inputs, wherein the evaluation circuits each possess a zone which is doped oppositely to the substrate, a first input gate, a second input gate and a transfer gate, wherein the transfer gate is arranged directly beside the transfer channel of the CTD shift register, the first input gate is connected to an input signal, the other input gate to a constant direct voltage, the oppositely doped zone to a first clock pulse train voltage, and the transfer gate to a second clock pulse train voltage, and wherein the output signal can be tapped from an output of the CTD shift register, characterised in that an evaluation circuit (82) is supplemented to form a pair of evaluation circuits by a further evaluation circuit (82') which is arranged on the opposite side of the transfer channel, where the oppositely doped zones (D, D1'), the input gate electrodes (G21, G22, G21', G22') and the transfer gate electrodes (G13, G13') of the two evaluation circuits (82, 82') are each connected to common terminals (14, 15, 2, B1) which are in turn connected to the first clock pulse train voltage, to the input signal to the constant direct voltage, and to the second clock pulse train voltage.

6. A transversal filter as claimed in claim 5, characterised in that a plurality of evaluation circuits (82, 83) are each supplemented to form a pair of evaluation circuits (82, 82'; 83, 83').

7. A transversal filter wherein the stages of an analogue CTD shift register integrated on a doped semiconductor substrate are provided with parallel inputs and with evaluation circuits assigned to said inputs, wherein the evaluation circuits each possess a zone which is doped oppositely to the substrate, a first input gate, a second input gate and a transfer gate, wherein the transfer gate is arranged directly beside the transfer channel of the CTD shift register, the first input gate is connected to a constant direct voltage, the oppositely doped zone is connected to a first clock pulse train voltage, and the transfer gate is connected to a second clock pulse train voltage, and wherein the output signal can be tapped from an output of the CTD shift register, characterised in that beneath the transfer gate electrodes (G13) of the individual evaluation circuits (81), in each case in the region of a predetermined number of shift electrodes (411) of the associated stages (401) of the shift register (4), there lies a thin film zone of the insulating layer which covers the surface of the semiconductor substrate, whereas in the region of the other shift electrodes (412 to 414) of the relevant stages (401) beneath the transfer gate electrode (G13) there lie thick film zones of the insulating layer, and that the number of the thin film zones beneath the transfer gate electrodes of the individual evaluation circuits (81 to 83) codetermine the values, formed therein, of the evaluation coefficients.

8. A transversal filter as claimed in one of claims 1, 3, 5 or 7, characterised in that the width of the second input gate electrodes (G12) of the evaluation circuits (81) corresponds to the length of one stage (401) of the CTD shift register (4).

9. A transversal filter as claimed in one of the claims 1, 3, 5 or 7, characterised in that it is designed as a semiconductor circuit monolithically integrated on a semiconductor substrate.

## Revendications

1. Filtre transversal, dans lequel les étages d'un registre à décalage CTD analogique, intégré sur un substrat semiconducteur dopé, sont pourvus d'entrées parallèles et de circuits de pondération associés à ces dernières, dans lequel chacun des circuits de pondération comporte une zone dopée en sens opposé par rapport au substrat, une première et une seconde portes d'entrée et une grille de transfert, la grille de transfert étant disposée directement près du canal de transfert du registre à décalage CTD, la première porte d'entrée recevant un signal d'entrée, la seconde porte d'entrée étant à une tension continue constante, la zone de dopage opposée recevant une première tension d'horloge et la grille de transfert une seconde tension d'horloge, et dans lequel le signal de sortie est susceptible d'être prélevé à une sortie du registre à décalage CTD, caractérisé par le fait que les zones (D1, D2, D3), dopées en sens opposé par rapport au substrat semiconducteur, des circuits de pondération (81, 82, 83) sont séparées l'une de l'autre et sont pourvues de bornes (141, 142, 143) qui leur sont propres et qui reçoivent les premières tensions d'horloge ($\phi_{D1}$, $\phi_{D2}$, $\phi_{D3}$) associées individuellement aux différents circuits de pondération et que les fréquences de répétition des impulsions des premières tensions d'horloge ($\phi_{D1}$, $\phi_{D2}$, $\phi_{D3}$) sont supérieures aux fréquences de répétition des impulsions d'une tension de cadence de décalage ($\phi_1$) du registre à décalage CTD (4) et sont choisies de telle manière qu'elles déterminent respectivement la grandeur des différents coefficients de pondération.

2. Filtre transversal selon la revendication 1, caractérisé par le fait que les secondes électrodes de porte d'entrée (G12, G22, G32) des circuits de pondération (81, 82, 83) sont réalisées avec des surfaces identiques entre elles.

3. Filtre transversal, dans lequel les étages d'un registre à décalage CTD analogique, intégré sur un substrat semiconducteur dopé, sont pourvus d'entrées parallèles et de circuits de pondération associés à ces dernières, dans lequel chacun des circuits de pondération comporte une zone dopée en sens opposé par rapport au substrat, une première et une seconde portes d'entrée et une grille de transfert, la grille de transfert étant disposée directement près du canal de transfert du registre à décalage CTD, la première porte d'entrée recevant un signal d'entrée, la seconde porte d'entrée étant à une tension continue constante, la zone de dopage opposée recevant une première tension d'horloge et la grille de transfert une seconde tension d'horloge, et dans lequel le signal de sortie est susceptible d'être prélevé à une sortie du registre à décalage CTD, caractérisé par le fait qu'un ou plusieurs circuits de pondération (82, 83) sont pourvus de zones supplémentaires ($D_{82}$, $D_{83}$) dopées en sens opposé par rapport au substrat, lesdites zones recevant une première tension de cadence supplémentaire ($\phi_D'$) qui est déphasée par rapport à la première tension d'horloge ou de cadence ($\phi_D$) appliquée aux zones ($D_g$) des circuits de pondération (81 à 83), qui sont dopées en sens opposé par rapport au substrat.

4. Filtre transversal selon la revendication 3, caractérisé par le fait que l'on prévoit des pistes conductrices isolées par rapport à la surface du substrat, pistes conductrices qui servent à appliquer la première tension d'horloge ou de cadence supplémentaire ($\phi_D'$) aux zones supplémentaires ($D_{82}$, $D_{83}$) des circuits de pondération (82, 83), qui sont dopées en sens opposé au substrat.

5. Filtre transversal, dans lequel les étages d'un registre à décalage CTD analogique, intégré sur un substrat semiconducteur dopé, sont pourvus d'entrées parallèles et de circuits de pondération associés à ces dernières, dans lequel chacun des circuits de pondération comporte une zone dopée en sens opposé par rapport au substrat, une première et une seconde portes d'entrée et une grille de transfert, la grille de transfert étant disposée directement prés du canal de transfert du registre à décalage CTD, la première porte d'entrée recevant un signal d'entrée, la seconde porte d'entrée étant à une tension continue constante, la zone de dopage opposée recevant une première tension d'horloge et la grille de transfert une seconde tension d'horloge, et dans lequel le signal de sortie est susceptible d'être prélevé à une sortie du registre à décalage CTD, caractérisé par le fait qu'un circuit de pondération (82) est complété, par un circuit de pondération supplémentaire (82') disposé sur le côté opposé du canal de transfert, en une paire de circuits de pondération, les zones ($D$, $D_1'$) dopées en sens opposé, des électrodes de porte d'entrée (G21, G22, G21', G22') et les électrodes de grille de transfert (G13, G13') des deux circuits de pondération (82, 82') étant respectivement reliées à des bornes communes (14, 15, 2, B1) qui reçoivent la première tension d'horloge ou de cadence.

6. Filtre transversal selon la revendication 5, caractérisé par le fait que plusieurs circuits de pondération (82, 83) sont chacun complétés en une paire de circuits de pondération.

7. Filtre transversal, dans lequel les étages d'un registre à décalage CTD analogique, intégré sur un substrat semiconducteur dopé, sont pourvus d'entrées parallèles et de circuits de pondération associés à ces dernières, dans lequel chacun des circuits de pondération comporte une zone dopée en sens opposé par rapport au substrat, une première et une seconde portes d'entrée et une grille de transfert, la grille de transfert étant disposée directement prés du canal de transfert du registre à décalage CTD, la première porte d'entrée recevant un signal d'entrée, la seconde porte d'entrée étant à une tension continue constante, la zone de dopage opposée recevant une première tension d'horloge et la grille de transfert une seconde tension d'horloge, et dans lequel le signal de sortie est susceptible d'être prélevé à une sortie du registre à décalage CTD, caractérisé par le fait qu'en-dessous des électrodes de grille de transfert (G13) des différents circuits de pondération (81), il est prévu, dans la voisinage d'un nombre prédéterminé d'électrodes de décalage (411) des étages associés (401) du registre à décalage (4), une zone en couche mince de la couche isolante qui recouvre la surface du substrat semiconducteur, alors que dans le voisinage des autres électrodes de décalage (412 à 414) des étages correspondants (401), on prévoit, en-dessous de l'électrode de grille de transfert (G13) des plages à couche épaisse de la couche isolante, et que le nombre des plages en couche mince en-dessous des électrodes de grille de transfert des différents circuits de pondération (81 à 83) participent à la détermination des valeurs des coefficients de pondération qui y sont formés.

8. Filtre transversal selon l'une des revendications 1, 3, 5, 7, caractérisé par le fait que la largeur des secondes électrodes de porte d'entrée (G12) des circuits de pondération (81), correspond à la longueur d'un étage (401) du registre à décalage CTD (4).

9. Filtre transversal selon l'une des revendications 1, 3, 5 ou 7, caractérisé par le fait qu'il est réalisé sous la forme d'un circuit à semiconducteurs monolithique intégré sur un substrat semiconducteur.

FIG 1

0004563

FIG 2

# FIG 3

FIG 4

FIG 5

FIG 6

$\phi_4$
$\phi_3$
$\phi_2$
$\phi_1$

401                402                403

4~

411 412 413 414   421 422 423 424

15($\phi_G$)

G13

2($U_e$)      E12    G12      E22    G22      E32    G32

B1(U1)                           G11                              G31

D83

D

G21    D82

14($\phi_D$)

81                82                83

14'($\phi'_D$)

A82                A83

0 004 563

0 004 563

FIG 7

7

# FIG 8

# FIG 9

0 004 563

# FIG 10